**Europäisches Patentamt**

(19) **European Patent Office**

**Office européen des brevets**

(11) Veröffentlichungsnummer: **0 028 739 B1**

(12) **EUROPÄISCHE PATENTSCHRIFT**

(45) Veröffentlichungstag der Patentschrift:
27.03.85

(21) Anmeldenummer: **80106481.7**

(22) Anmeldetag: **23.10.80**

(51) Int. Cl.⁴: **H 01 L 21/265,** H 01 L 21/324, H 01 L 29/08, H 01 L 21/20

(54) **Verfahren zum Bilden der Emitterzone eines Transistors.**

(30) Priorität: **13.11.79 US 93666**

(43) Veröffentlichungstag der Anmeldung:
**20.05.81 Patentblatt 81/20**

(45) Bekanntmachung des Hinweises auf die Patenterteilung:
**27.03.85 Patentblatt 85/13**

(84) Benannte Vertragsstaaten:
**DE FR GB**

(56) Entgegenhaltungen:
**EP - A - 0 002 472
DE - A - 1 933 690
DE - A - 2 618 733
US - A - 4 099 987
US - A - 4 109 273
US - A - 4 133 704**

**JOURNAL OF THE ELECTROCHEMICAL SOCIETY, Band 126, Nr. 7, 1979, PRINCETON (US), M. WITTMER et al. "The influence of noble gas atoms on the epitaxial growth of implanted and sputtered amorphous silicon", Seiten 1247-1252**

(73) Patentinhaber: **International Business Machines Corporation, Old Orchard Road, Armonk, N.Y. 10504 (US)**

(72) Erfinder: **Chu, Wei-Kan, 22 Wayne Drive, Poughkeepsie, NY 12601 (US)**
Erfinder: **Magdo, Ingrid Emese, Frances Drive, Hopewell Junction, NY 12533 (US)**
Erfinder: **Rupprecht, Hans Stephan, 3505 Kamhi Drive, Yorktown Heights, NY 10598 (US)**

(74) Vertreter: **Rudack, Günter O., Dipl.-Ing., c/o International Business Machines Corporation Zurich Patent Operations Säumerstrasse 4, CH-8803 Rüschlikon (CH)**

**Beschreibung**

Die Erfindung betrifft ein Verfahren zum Bilden einer Emitterzone eines Transistors gemäß dem ersten Teil des Anspruchs 1. Ein derartiges Verfahren ist aus der US-A-4 109 273 bekannt.

Transistorstrukturen sind allgemein bekannt. Normalerweise wird für die Herstellung eines NPN-Transistors eine hochdotierte N+-leitende Subkollektorzone in die Hauptfläche eines Halbleitersubstrats eindiffundiert. Dann wird über der Oberfläche des Substrats eine epitaxidale Schicht aufgewachsen. Die Subkollektorzone dringt dabei während des Niederschlagens der epitaxialen Schicht durch Ausdiffusion in diese ein. Anschließend wird eine Basiszone durch Eindiffundieren eines P-leitenden Störelementes in die epitaxiale Schicht in Berührung mit der Subkollektorzone gebildet. Dann wird ein N-leitendes Störelement, wie z. B. Arsen oder Phosphor, zur Bildung der Emitterzone des Transistors in die Basiszone eindiffundiert. Die Emitterzone liegt damit vollständig unterhalb der Oberfläche und innerhalb der Basiszone der epitaxialen Schicht.

Das dabei wegen seiner Wirtschaftlichkeit und seinen besseren Steuerungsmöglichkeiten bevorzugte Verfahren besteht darin, daß das zur Bildung der Emitterzone einzudiffundierende Störelement durch Ionenimplantation eingebracht wird. Es kann jedoch nicht übersehen werden, daß die Verwendung von Ionenimplantation zur Bildung einer Emitterzone innerhalb der Basiszone einer epitaxial aufgewachsenen Schicht zu zahlreichen Schwierigkeiten geführt hat.

Während der Ionenimplantation wird die monokristalline Struktur der epitaxialen Schicht aufgrund der Strahlungsschäden stark beeinträchtigt, wenn nicht gar zerstört.

Nach Beendigung des Ionenbeschusses muß die kristalline Struktur dadurch wiederhergestellt werden, daß das Material einer Wärmebehandlung zum Anlassen unterzogen wird. Obgleich diese Wärmebehandlung zum Anlassen ausreicht, den größten Teil der zerstörten kristallinen Struktur wieder herzustellen, bleiben doch einige Restschäden der Struktur übrig. Diese kristallinen Defekte können aber das Betriebsverhalten des Transistors beeinträchtigen. Außerdem bewirkt die zum Anlassen durchgeführte Wärmebehandlung, daß die implantierten, dotierenden Ionen weiter in die Basiszone eindringen. Das Eintreiben implantierter, dotierender Ionen hat zur Folge, daß die Tiefe der Emitterzone größer wird, als erwünscht. Außerdem liefert die Nachbarschaft der Seitenflächen der Emitterzone zusammen mit der diesen Seitenflächen der Emitterzone benachbarten Teilen der Basiszone eine Streukapazität, die höher ist, als erwünscht.

Eine weitere Schwierigkeit besteht darin, daß die nachfolgende Metallisierung der Emitterzone auf der Oberfläche der epitaxialen Schicht stattfindet. Üblicherweise wird dabei auf der Siliziumoberfläche über der Emitterzone Platin niedergeschlagen. Durch nachfolgende Behandlung erhält man auf der Oberfläche Platinsilicid. Das zur Bildung des Platinsilicids nötige Silicium wird jedoch dem Silicium der epitaxial aufgewachsenen Schicht entnommen, und dabei tritt auch noch ein seitliches Wachstum der Platinsilicidschicht auf. Ein solches seitliches Wachstum kann jedoch einen Kurzschluß zwischen Emitterzone und Basiszone an der Oberfläche zur Folge haben. Wegen der außerordentlich geringen Zwischenräume, die bei der Bildung von Transistoren üblich sind, ist die Möglichkeit eines derartigen Kurzschlusses zwischen Emitter und Basis durchaus gegeben und stellt ein ständig auftretendes Problem dar.

Es wäre daher erwünscht, einen Transistor zu schaffen, bei dem der Kontakt zwischen Seitenfläche der Basiszone und Emitter soweit verringert wird, daß dadurch auch die Streukapazität zwischen Emitter- und Basiszone verringert wird. Es wäre außerdem wünschenswert, wenn man eine Transistorstruktur hätte, bei der die Emitterzone flacher ist, wobei mindestens ein Teil der Emitterzone von der Basiszone isoliert ist. Ein Transistor mit einer kleineren Emitterzone kann viel schneller vom leitenden in den nichtleitenden Zustand und umgekehrt, umschalten. Es wäre außerdem erwünscht, wenn man eine Emitterstruktur hätte, bei der die Metallisierung an einem Ort stattfindet, wo nicht die Gefahr einer Kontaktbrücke besteht.

Aus dem Dokument EP-A-0 002 472 ist ein Verfahren zum Bilden der Emitterzone eines Transistors bekannt, bei dem eine mit dem Leitfähigkeitstyp des Emitters dotierte, nicht-monokristalline Siliziumschicht auf eine nicht-monokristalline Schicht vom Leitungstyp der Basis niedergeschlagen wird und bei dem anschließend der Transistor zum Umwandeln des nicht-monokristallinen Siliziums in monokristallines Silizium angelassen wird.

Mit Hilfe des erfindungsgemäßen Verfahrens wird ein Transistor geschaffen, dessen Emitterbereich zunächst aus nicht-monokristallinem Silicium hergestellt wird, das während der weiteren Herstellung des Transistors in monokristallines Silicium umgewandelt wird.

Zunächst wird eine Subkollektorzone in einem Halbleitersubstrat gebildet. Der in der Subkollektorzone vorhandene Dotierungsstoff diffundiert durch Ausdiffusion in eine nachträglich niedergeschlagene expitaxiale Schicht hinein. In dieser epitaxialen Schicht wird eine Basiszone gebildet, deren Leitungstyp dem Leitungstyp der Subkollektorzone entgegengesetzt ist. Dadurch erhält man einen PN-Übergang zwischen der Basiszone und den aus der Subkollektorzone ausdiffundierten Störelementen, die die Kollektorzone des Transistors bilden.

Auf der epitaxialen Schicht wird dann erfindungsgemäß eine Schicht aus nicht-monokristallinem Silicium niedergeschlagen. Mindestens ein Teil dieser nicht-monokristallinen Sil<nobr>-</nobr>ciumschicht bildet einen Raumbereich für eine Emitterzone, die der Basiszone benachbart und in vertikaler Richtung teilweise von ihr beabstandet ist. Der Raumbereich für die Emitterzone wird dann mit Ionen bombardiert, die den gleichen Leitungstyp ergeben, wie ihn die Subkollektorzone aufweist. Die Ionenbombardierung wird mit einer Dosierung und einem Energieniveau durchgeführt, das ausreicht, ein Teil der Gauss'schen Verteilung der Eindringstiefen der Ionen über der Trennfläche zwischen der monokristallinen Schicht und der epitaxialen Schicht in die Basiszone hineinzuverlagern. Danach wird die Gesamtstruktur in geeigneter Weise angelassen, so daß ein Teil der Ionen tiefer in die Basiszone eingetrieben wird und das nicht-monokristalline Silizium des Raumbereichs der Emitterzone in eine Emitterzone aus monokristallinem Silicium umgewandelt wird.

Die sich dabei ergebende Struktur hat den Vorzug, daß die Gesamttiefe der Emitterzone kleiner ist als bei einer durch unmittelbare Bombardierung der epitaxialen Schicht mit Ionen gebildeten Emitterzone. Außerdem ist der seitliche Kontakt zwischen Emitterzone und Basiszone stark verringert und die unerwünschte Streukapazität von Emitterzone nach Basiszone ist wesentlich herabgesetzt. Ein weiterer wesentlicher Vorteil der Erfindung liegt darin, daß die Emitterzone an einer Stelle metallisiert werden kann, die von der Oberfläche der epitaxialen Schicht einen Abstand aufweist, so daß dadurch die Gefahr des Eindringens von Metall vermieden wird. Ein weiterer unerwarteter Vorteil der Erfindung besteht darin, daß der erfindungsgemäß hergestellte Transistor im Vergleich mit Transistoren des Standes der Technik eine wesentlich bessere Verstärkung aufweist.

Die Erfindung wird nunmehr anhand eines Ausführungsbeispiels in Verbindung mit den Zeichnungen im einzelnen näher erläutert. In den Zeichnungen zeigen

Fig. 1 bis 4 verschiedene Stufen bei der Herstellung eines Halbleitertransistors gemäß einem bekannten Verfahren,

Fig. 5 bis 9 verschiedene Stufen bei der Herstellung eines Halbleitertransistors nach dem erfindungsgemäßen Verfahren,

Fig. 10 bis 14 vergrößerte Ansichten der epitaxialen Oberflächenschicht, der Polysiliciumschicht und der Trennfläche während der Herstellung einer Emitterzone nach dem erfindungsgemäßen Verfahren, und

Fig. 15 eine schematische Darstellung der Gauss'schen Verteilung der Ionen in der nicht-monokristallinen Schicht und in der epitaxial aufgewachsenen Schicht.

Für die bevorzugte Ausführungsform der Erfindung wird ein P-leitendes Siliciumsubstrat zur Bildung eines bipolaren NPN-Transistors verwendet. Selbstverständlich ist die Erfindung genauso auf die Herstellung eines bipolaren Transistors entgegengesetzter Leitfähigkeit anwendbar. Wenn dieses Verfahren analog für die Bildung eines N-leitenden Kanals oder eines P-leitenden Kanals bei Feldeffekttransistoren eingesetzt wird, so ergibt sich keine Verbesserung der Betriebseigenschaften. Jedoch läßt sich das Verfahren beispielsweise leicht dahin abwandeln, daß Feldeffekttransistoren während der gleichzeitigen Herstellung von bipolaren Transistoren ebenso leicht gefertigt werden können.

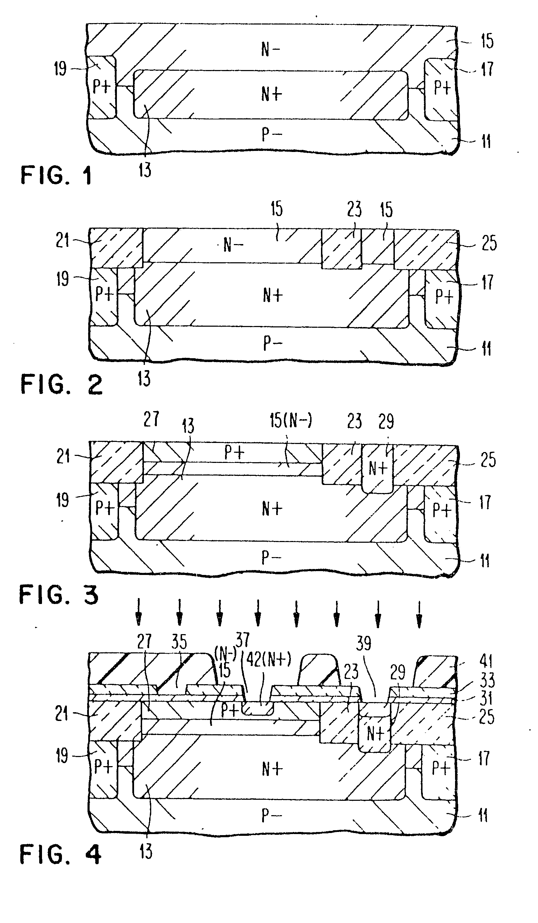

In den Fig. 1 bis 4 sind verschiedene Stufen eines üblichen Herstellungsverfahrens für bipolare Transistoren gezeigt. Verschiedene Verfahrensschritte, wie z. B. thermische Oxidation, Maskieren und Ätzen, die allgemein bekannt sind, sind in der Folge der Verfahrensschritte in den Fig. 1 bis 4 nicht besonders gezeigt. Wie aus Fig. 4 zu erkennen, weist das Halbleiterplättchen 11 eine darin liegende, durch thermische Diffusion eines N-leitenden Störelements, wie z. B. Phosphor, Arsen, Antimon oder dgl. hergestellte N$^+$-leitende Zone 13 auf. Die N$^+$-leitende Zone 13 wird durch eine Öffnung in einer Oxidschicht nach üblichen Verfahrensschritten hergestellt. Aus dem Fachmann bekannten Gründen ist Arsen bei der Bildung der Zone 13 vorzuziehen, die anschließend als vergrabene Subkollektorzone des NPN-Transistors dienen soll. Zu Beginn beträgt die Konzentration $C_0$ von Arsen vorzugsweise mehr als $10^{21}$ Atome/cm$^3$.

Auf der Oberfläche des Halbleiterplättchens 11 wird eine epitalxiale Schicht 15 gebildet. Während der Bildung der epitaxialen Schicht 15 diffundiert die N$^+$-leitende Zone 13 in die epitaxiale Schicht 15 hinein, wie dies Fig. 1 zeigt. Außerdem werden P-leitende Zonen 17 und 19 vor Bildung der Epitaxialschicht 15 in die Oberfläche des Halbleiterplättchens 11 eindiffundiert. Die P$^+$-leitenden Zonen dienen der Isolation. Während der Bildung der epitaxialen Schicht 15 diffundieren die P$^+$-leitenden Zonen 17 und 19 ebenfalls aus. Die P$^+$-leitenden Zonen 17 und 19 werden durch übliche Diffusionsverfahren gebildet, wobei als Störelement vorzugsweise Bor verwendet wird, obwohl auch andere P$^+$-leitende Störelemente verwendbar sind. Die anfängliche Konzentration des Bors, $C_0$, liegt vorzugsweise bei $\geq 10^{20}$ Atomen/cm$^3$.

Wie man anschließend am besten aus Fig. 2 erkennt, werden versenkte Oxidisolationszonen 21, 23 und 25 in der epitaxialen Schicht 15 gebildet. Ein Verfahren zur Bildung solcher versenkter Oxidisolationszonen in monokristallinem Silicium ist in der US-Patentschrift 4 044 454 der Anmelderin beschrieben. Bei diesem Verfahren werden diejenigen Oberflächen der Halbleiterplättchen, bei denen keine versenkten Oxidisolationszonen gebildet werden, durch ein isolierendes Material, wie z. B. Siliciumnitrid abgedeckt. Dann werden an denjenigen Stellen der Siliciumnitridschicht, an denen eingelassene Oxidisolationszonen gebildet werden sollen, Öffnungen hergestellt. Die freiliegenden monokristallinen Zonen werden dann zunächst geätzt und dann thermisch durchoxidiert, so daß die Oxidation bis nach der P$^+$-leitenden Zonen 17 und 19 und nach der N$^+$-leitenden Subkollektorzone 13 reichen.

Nach Bildung der eingelassenen Oxidationszonen werden selektiv Diffusionen in die Epitaxialschicht 15 zur Bildung einer N+-leitenden Zone 29 hergestellt. Diese Zone 29 dient dann als Kollektorkontakt. Die anfängliche Konzentration $C_0$ des N+-leitenden Störelements, vorzugsweise Arsen, liegt vorzugsweise bei $\geqq 10^{20}$ Atomen/cm³.

Dann wird in der Oberfläche der epitaxialen Schicht 15 eine P+-leitende Basiszone 27 in geeigneter Weise, wie z. B. durch Diffusion oder Ionenimplantation gebildet. Die Diffusion wird dabei vorzugsweise mit Bortriborat mit einer Anfangsoberflächenkonzentration von $4 \cdot 10^{19}$ Atomen/cm³ vorgenommen. Diese Konzentration wird anschließend durch Reoxidation in der Basiszone verringert. Die Basis kann außerdem mit einer Ionenimplantation durch eine Oxidschicht durchgeführt werden, wobei $C_0$ annähernd $10^{18}$ Atome/cm³ beträgt. Wenn die Subkollektorzone 13 so weit ausdiffundiert hat, daß sie in Kontakt mit der Basiszone 27 kommt, dann ergibt dieser Schnitt zweier sehr stark dotierter Übergänge eine niedrige Durchschlagsspannung. Wenn jedoch eine höhere Durchschlagsspannung gewünscht wird, dann wird man einen Teil der N-leitenden epitaxialen Schicht zwischen die P+-leitende Basiszone 27 und die N+-leitende Subkollektorzone 13 legen. Die Förderung der Ausdiffusion der Subkollektorzone zu diesem Zweck ist in der der Anmelderin gehörenden US-Patentschrift 4 016 596 beschrieben.

Wie aus Fig. 4 zu ersehen, werden dann eine Siliciumdioxidschicht 31 und eine Siliciumnitridschicht 33 auf der Oberfläche der epitaxialen Schicht auf übliche Weise niedergeschlagen. Anschließend wird in der Siliciumnitridschicht 33 eine Öffnung 35 und Öffnungen 37 und 39 durch die Siliciumnitridschicht 33 und die Siliciumdioxidschicht 31 hergestellt. Anschließend wird ein Photolack 41 zur Maskierung der Öffnung 35 aufgebracht, der jedoch die Öffnungen 37 und 39 für eine Implantation von N+-dotierenden Ionen zur Bildung der Emitterzone 42 und der Kollektorkontaktzone 39 freiläßt.

Zur Herstellung von Emitterzonen innerhalb einer P-leitenden Basiszone wird heute bevorzugt Ionenbombardierung oder Ionenimplantation verwendet. Im allgemeinen läuft eine Ionenimplantation bei einem Energieniveau von annähernd 50 KeV und einer Dosierung von annähernd $1 \cdot 10^{16}$ für die Implantierung einer maximalen Konzentration von etwa $10^{21}$ bis etwa $5 \cdot 10^{21}$ Atomen/cm³ in die Oberfläche der P+-leitenden Basiszone 27 ab. Während der Ionenimplantation der monokristallinen Struktur der epitaxialen Schicht wird diese aufgerissen und erleidet starke Strukturschäden. Diese Strukturschäden werden mindestens zum Teil durch Anlassen der Transistorstruktur bei einer Temperatur von 900 bis 1000° C für eine Dauer von etwa 30 bis 60 Minuten geheilt. Obgleich dieses Anlaßverfahren die meisten durch die implantierten Ionen verursachten Störungen der Kristallstruktur beseitigt und die meisten implantierten Ionen elektrisch wieder aktiviert, so gibt es doch immer noch eine merkliche Anzahl von Dislozierungen in der Emitterstruktur und diese neigen dazu, das Betriebsverhalten zu beeinträchtigen. Außerdem wird durch das Anlaßverfahren die Ausdiffusion der N+-leitenden Ionen bewirkt, so daß sich die Emitterzone, von der Oberfläche der Epitaxialschicht aus gesehen, ausdehnt.

Allgemein gesprochen, bewirkt die ursprüngliche Ionenbombardierung eine Implantation der am tiefsten eindringenden Ionen bis zu einer Tiefe von etwa 30 nm bis etwa 40 nm. Die durch Anlassen bewirkte Ausdiffusion hat zur Folge, daß sich die Emitterzone bis zu einer Tiefe von etwa 300 bis etwa 500 nm ausdehnt. Will man die meisten der so aufgetretenen Strukturdefekte durch Anlassen beseitigen, so ist es gewöhnlich nicht möglich, nach dem Anlassen unter Verwendung von Ionenimplantation in die epitaxiale Oberflächenschicht eine Emittertiefe von weniger als 200 nm zu erzielen. Da eine Streukapazität zwischen dem Übergang von der P+-leitenden Basiszone nach der Emitterzone hervorgerufen wird, ist es erwünscht, die Tiefe der Emitterzone zu beschränken sowie das Ausmaß des Übergangs zwischen der Seitenfläche der Emitterzone und der Basiszone einzuschränken.

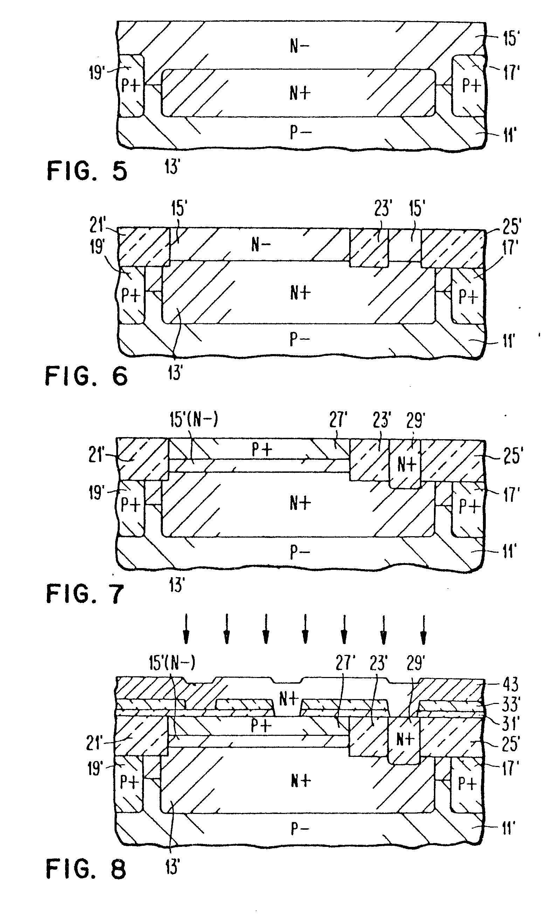

In Zusammenhang mit den Fig. 5 bis 10 soll das erfindungsgemäße Verfahren zum Herstellen einer Transistorstruktur beschrieben werden. Im allgemeinen zeigen Fig. 5 bis 8 Verfahrensstufen bei der Herstellung einer Transistorstruktur, die die gleichen sind, wie die zuvor in bezug auf Fig. 1 bis 4 beschriebenen Verfahrensstufen. Gleiche Teile sind daher mit gleichen, aber gestrichenen Bezugszeichen verwendet.

Die Siliciumdioxidschicht 31' und die Siliciumnitridschicht 33' werden, wie in Fig. 8 gezeigt, niedergeschlagen und anschließend werden Öffnungen 35', 37' und 39' hergestellt.

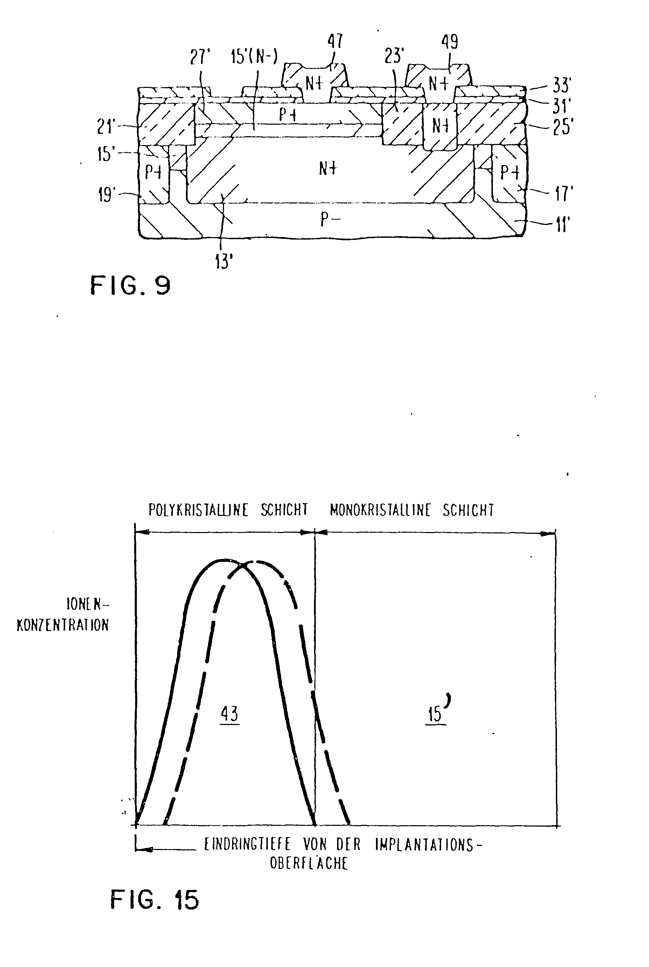

Eine Schicht 43 aus nicht-monokristallinem Silicium (das manchmal auch als Polysilicium bezeichnet wird), wird dann auf der Oberfläche der Transistorstruktur niedergeschlagen. Wie in Fig. 8 zu erkennen, füllt die Schicht aus polykristallinem Silicium die Öffnungen 35', 37' und 39' aus. Es ist selbstverständlich einleuchtend, daß die in Fig. 8 und 9 dargestellte Struktur in ihren Größenverhältnissen stark übertrieben ist. Die Siliciumdioxidschicht ist im allgemeinen zwischen 40 und 80 nm stark, die Siliciumnitridschicht 33 hat im allgemeinen eine Dicke von etwa 100 bis etwa 200 nm. Die Polysiliciumschicht hat im allgemeinen eine Dicke von 50 bis 150 nm. Die Vertiefungen über den Bereichen der Öffnungen 35, 37 und 39 sind jedoch ohne große Bedeutung.

Nach Niederschlagen der polykristallinen Schicht 43 wird diese polykristalline Schicht einer Ionenimplantation in den Bereichen in der Nachbarschaft der Öffnung 37' unterzogen die als Raumbereich zu betrachten ist, der später die Emitterzone des bipolaren Transistors bildet. Es ist dabei nicht erforderlich, während der Ionen-

implantation die Transistorstruktur mit einer Maske zu versehen, da andere Bereiche außerhalb der Öffnungen 37' und 39' durch eine Schicht aus SiO2 oder eine Schichtenfolge aus SiO2/Si3N4 überdeckt sind. Es ist nur erforderlich, daß die Ionenimplantation über der Oberfläche der Öffnung 37 vor sich geht. Danach wird die Transistorstruktur für eine so lange Zeit angelassen, daß die implantierten Ionen tiefer in die Basiszone unterhalb der Öffnung 37 eingetrieben werden und das polykristalline Silicium in monokristallines Silicium umgewandelt wird.

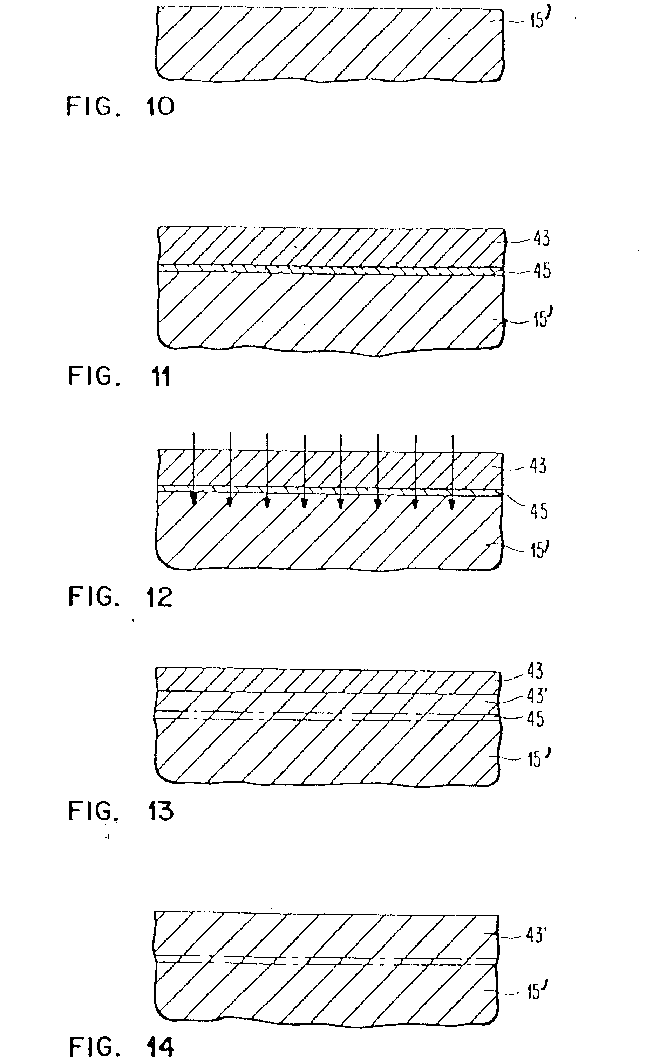

Das Verfahren gemäß der vorliegenden Erfindung ist wohl am besten verständlich, im bezug auf die Fig. 10 bis 14 und das Diagramm der Fig. 15. Das ursprünglich monokristalline Silicium der epitaxialen Schicht 15', ist in Fig. 10 dargestellt. Obgleich die ursprüngliche Siliciumschicht 15 zur Erläuterung des erfindungsgemäßen Verfahrens als praktisch undotiert dargestellt ist, so würde doch in der Praxis die epitaxiale Schicht 15' verschiedene Zonen und Bereiche unterschiedlicher Leitungstypen und Konzentrationen aufweisen, wie z. B. die $P^i$-leitende Basiszone 27'. In Fig. 11 wird auf der epitaxialen Schicht 15' aus monokristallinem Silicium eine Schicht 43 aus Polysilicium niedergeschlagen. Das polykristalline Silicium kann dabei entweder durch übliche Niederdruckverfahren mit chemischem Niederschlag aus der Dampfphase bei Temperaturen in der Größenordnung von 650°C durchgeführt werden, wobei der Siliciumdampf aus Quellen, wie Silan oder Siliciumtetrachlorid, abgeleitet wird. Andererseits kann auch eine Schicht aus polykristallinem Silicium durch übliche Verdampfungsverfahren aufgebracht werden, wie sie beispielsweise durch C. Canali et al., im Journal of Applied Physics Band 46, Nr. 7, Juli 1975 auf Seiten 2831—2835 beschrieben werden, mit der Ausnahme, daß das Silicium unmittelbar auf das Siliciumsubstrat oder durch Niederschlag mit Kathodenzerstäubung aufgebracht wird. Für die vorliegende Darstellung beträgt die Schichtdicke der polykristallinen Schicht 43 etwa 80 nm.

Es sei darauf hingewiesen, daß zwar das polykristalline Silicium als Schicht 43 unmittelbar auf einem monokristallinem Siliciumsubstrat niedergeschlagen wird, daß sich dabei aber erwartungsgemäß während dieser Verfahrensschritte Siliciumdioxid bildet. Obgleich diese Siliciumdioxidschicht höchstens eine Dicke in der Größenordnung von 0,5 bis 2 nm aufweist und eine unterschiedliche Kontinuität besetzt, so ist doch der Einfachheit der Darstellung halber diese Siliciumdioxidschicht in Fig. 11 als Schicht 45 angedeutet.

Als nächstes wird gemäß Fig. 12 das Substrat einer Ionenimplantation mit einem dotierenden Ion, wie z. B. Arsen, ausgesetzt. Die Bombardierung kann dabei unter Verwendung üblicher Ionenimplantationsvorrichtungen bei einem Energieniveau und einer Dosierung durchgeführt werden, die ausreicht, die Gauss'sche Verteilung der bombardierenden Ionen über der Trennfläche zwischen der polykristallinen Schicht 43 und der monokristallinen epitaxialen Schicht 15' zu verschieben und zwar in die $P^+$-leitende Basiszone 27' hinein. Dieses Erfordernis ist am besten im Zusammenhang mit Fig. 15 zu sehen. Wie aus Fig. 15 zu erkennen ist, bildet der Konzentrationsgradient der sich aus der Ionenimplantation ergebenden Ionen eine Gauss'sche Verteilungskurve. Bei verschiedenen Energieniveaus und Dosierungen liegt der Konzentrationsgradient vollständig innerhalb der polykristallinen Schicht, wie dies durch die ausgezogene Linie in Fig. 15 dargestellt ist. Wenn die Gauss'sche Verteilung vollständig innerhalb der polykristallinen Schicht liegt, dann wird ein nachfolgender Anlaßvorgang das polykristalline Silicium der Schicht nicht in den monokristallinen Zustand umsetzen. Wenn jedoch die Dosierung einen vorbestimmten Schwellwert für das bestimmte zu implantierende Ion überschreitet und die Energieniveaus ausreichend hoch sind um die Gauss'sche Verteilung über die Trennfläche zwischen polykristalliner Schicht und monokristalliner Schicht zu verschieben, dann wird ein nachfolgender Anlaßvorgang bewirken, daß die Polysiliciumschicht sich in einen monokristallinen Zustand umwandelt.

Unter Verwendung von Arsenionen reicht ein Ionenbombardement bei Zimmertemperatur und einem Energieniveau von 50 bis 200 KeV und einer Dosierung von mindestens $10^{16}$ Ionen/cm$^2$ aus, um die Gauss'sche Verteilung über die Trennfläche zwischen polykristalliner Schicht und monokristalliner Schicht zu verschieben. Sollte es erwünscht sein, eine geringere Dosierung der dotierenden Ionen zu verwenden, dann kann die Ionenbombardierung in zwei Stufen in der Weise durchgeführt werden, daß zunächst in der ersten Stufe ein dotierendes Ion verwendet wird und in der zweiten Stufe ein nicht dotierendes Ion, wie z. B. Silicium oder Wasserstoff. Das Zwei-Stufen-Verfahren kann außerdem zur Bildung von $P^+$-leitenden Emitterzonen eingesetzt werden, wenn die Dosierung der Implantation von $P^i$-leitenden Dotierungsionen unterhalb des Schwellwertpegels liegt, und/oder das Energieniveau nicht ausreicht, die Gauss'sche Verteilung über die Trennfläche zu verschieben.

Dann wird gemäß Fig. 13 und 14 die Transistorstruktur einem Anlaßzyklus unterworfen, wo durch geeignete Behandlung die implantierten Ionen elektrisch aktiviert werden. Die Schwellwertdosierung ist erforderlich, um Polysilicium amorph zu machen. Für eine spätere Rekristallisierung ist amorphes Polysilicium erforderlich. Da die implantierten Ionen das Oxid an der Trennfläche aufbrechen, läuft die Rekristallisierung bei relativ niedrigen Temperaturen ab. Dies ist tatsächlich ein im festen Zustand ablaufendes Verfahren mit epitaxialem Wachstum. Reicht die Dosierung nicht aus, um das an der Trennfläche vorhandene Oxid aufzubrechen, dann kann selbst bei sehr hohen Temperaturen keine Rekristallisation stattfinden. Während des Anlaßzyklus wächst, von der Trennfläche mit der monokristallinen epitaxialen Schicht 15 ausgehend, eine aus monokristallinem Silicium bestehende epitaxiale Schicht 43' durch Verbrauch der nunmehr amorphen polykristallinen Siliciumschicht 43 auf, die während dieses Wärmezyklus tatsächlich in monokristallines Silicium umgewandelt wird. Wie durch die gestrichelte Zone 45 in den Fig. 13 und 14 angedeutet, ist tatsächlich alles Siliciumdioxid, das als Schicht 45 an der Trennfläche vorhanden war, verschwunden und stört daher die Bildung der aus monokristallinem Silicium bestehenden Epitaxialschicht 43' nicht.

Das Anlassen kann durch Laserstrahlen, Elektronenstrahlen oder durch übliche Wärmebehandlung, wie z. B. Aufheizen der Transistorstruktur, durchgeführt werden. Die Wärmebehandlung durch thermisches Anlassen kann durch jeden beliebigen Zeit-/Temperaturzyklus erreicht werden, der sich zum Anlassen und damit zum Beseitigen von Störungen an der Trennfläche in üblicher Weise eignet. Für das vorliegende Ausführungsbeispiel wird für den bevorzugten Wärmezyklus zum Anlassen ein zweistufiges Verfahren bevorzugt, wobei zunächst in einer ersten Stufe die Temperatur für zwei Stunden auf 550°C gehalten wird, während anschließend die Temperatur auf 900°C erhöht, und die Transistorstruktur für eine Stunde bei 900°C gehalten wird. Bei einem einstufigen Wärmezyklus wird die Transistorstruktur für etwa 30 Minuten bis etwa 4 Stunden bei einer Temperatur von etwa 800°C bis etwa 1000°C gehalten. Für beste Ergebnisse sollte die höchste Temperatur im Anlaßzyklus nicht höher liegen, also 1000°C, um jede Ausdiffusion klein zu halten. Wie aus Fig. 14 zu erkennen, setzt sich die Umwandlung der polykristallinen Siliciumschicht 43 in eine monokristalline epitaxiale Schicht 43' solange fort, bis die Schicht 43 vollständig rekristallisiert ist und die sich dabei ergebende Struktur aus einer monokristallinen Siliciumschicht 43' über der monokristallinen, epitaxialen Schicht 15 besteht. Das allgemeine Verfahren zum Umwandeln nicht-monokristallinen Siliciums in monokristallines Silicium nach Bombardierung mit neutralen Ionen ist in der US-Patentschrift 3 900 445 offenbart.

Es sei darauf hingewiesen, daß dann, wenn die niedergeschlagene polykristalline Siliciumschicht 43 geringfügig dicker ist, als für die endgültig zu bildende aus monokristallinem Silicium bestehende Epitaxialschicht 43' nötig ist, die Siliciumschicht 43 nicht vollständig in die monokristalline Siliciumschicht 43' umgewandelt werden muß. Zu einem geeigneten Zeitpunkt vor dem Ende der Umwandlung, kann die Struktur einer üblichen, thermischen Oxidation in situ für eine kurze Zeit ausgesetzt werden, die ausreicht, um das verbleibende amorphe Silicium der Schicht in Siliciumdioxid umzuwandeln. Diese Siliciumdioxidschicht kann dann anschließend selektiv von der Oberfläche der Struktur unter Verwendung eines Ätzmittels, wie beispielsweise gepufferten Flußsäure, entfernt werden, die selektiv das so gebildete Siliciumdioxid abätzt und damit die Oberfläche der gebildeten monokristallinen, epitaxialen Schicht 43' freilegt.

Wie in Fig. 9 zu ersehen, wird die so gebildete monokristalline, epitaxiale Schicht 43' selektiv entfernt und bildet damit eine Emitterzone 47 und einen Kollektorkontakt 49. Die nachfolgende Bildung von Ohm'schen Kontakten und Metallisierungen (nicht gezeigt) für die einzelnen Halbleitervorrichtungen kann auf übliche Weise vorgenommen werden. Es sei jedoch darauf verwiesen, daß die Möglichkeit eines Kurzschlusses vom Emitterkontakt nach der Basiszone dadurch beseitigt ist, daß zwischen Basiszone und Emitterzone teilweise ein Abstand in senkrechter Richtung besteht. Diese Beseitigung der Kurzschlußprobleme wird selbst bei sehr flachen Emitterstrukturen beibehalten.

Eine weitere Eigenschaft dieses erfindungsgemäß aufgebauten und hergestellten Emitterzone des Transistors besteht darin, daß die Verstärkung des Transistors gegenüber bisher bekannten Transistorstrukturen um etwa 50 bis 65% verbessert worden ist. Der Grund für diese wesentliche und überraschende Verbesserung im Betriebsverhalten des Transistors ist nicht bekannt. Es ist offensichtlich, daß die Kombination aus verbessertem Betriebsverhalten und einfacherer Herstellung neue und einzigartige Eigenschaften des erfindungsgemäß aufgebauten und hergestellten Emitterzone des Transistors sind.

## Patentansprüche

1. Verfahren zum Bilden der Emitterzone eines Transistors, mit einer in einem Halbleitersubstrat angeordneten Subkollektorzone (13'), einer darüberliegenden, epitaxial aufgewachsenen Schicht (15') und einer innerhalb dieser Schicht liegenden Basiszone (27') eines zum Leitungstyp der Subkollektorzone entgegengesetzten Leitungstyps, bei dem eine Schicht (43) aus nicht-monokristallinem Silicium über der epitaxial aufgewachsenen Schicht (15') niedergeschlagen und mit Ionen des gleichen Leitungstyps wie der der Subkollektorzone implantiert wird, dadurch gekennzeichnet, daß mindestens ein Teil des nicht-monokristallinen Siliciums einen Raumbereich für die Emitterzone bildet, der der Basiszone benachbart und in vertikaler Richtung teilweise von ihr beabstandet ist, daß der Raumbereich der Emitterzone mit Ionen mit solcher Dosierung und so hoher Energie bestrahlt wird, daß mindestens ein Teil der Gauss'schen Verteilung der Eindringtiefen dieser Ionen über die Trennfläche zwischen der nicht-monokristallinen Schicht (43) und der epitaxialen Schicht (15') verschoben wird, und daß der Transistor zum Eintreiben der Ionen in die Basiszone und zum Umwandeln des nicht-monokristallinen Siliciums des Raumbereichs der Emitterzone in eine aus monokristallinem Silicium bestehende Emitterzone angelassen wird.

2. Verfahren nach Anspruch 1, dadurch gekennzeichnet, daß die nicht-monokristalline Schicht (43) mit einer Dicke von etwa 50 bis etwa 150 nm aufgebracht wird.

3. Verfahren nach Anspruch 1 oder 2, dadurch gekennzeichnet, daß der Raumbereich der Emitterzone (47) mit einer Kombination aus dotierenden Ionen und neutralen Ionen bestrahlt wird.

4. Verfahren nach einem der Ansprüche 1 bis 3, dadurch gekennzeichnet, daß der Transistor zum Anlassen für eine ausreichend lange Zeit auf eine für eine Umwandlung des nicht-monokristallinen Siliciums des Raumbereichs der Emitterzone in eine aus monokristallinem Silicium bestehende Emitterzone ausreichende Temperatur erhitzt wird.

5. Verfahren nach Anspruch 4, dadurch gekennzeichnet, daß die Wärmebehandlung bei einer Temperatur von etwa 800° C bis etwa 1000° C für etwa 30 Minuten bis etwa 4 Stunden durchgeführt wird.

## Claims

1. Method for forming the emitter region of a transistor comprising a subcollector region (13') in a semiconductor substrate, an epitaxially grown layer (15') thereon, and a base region (27') within the latter layer, having a conductivity type opposite to the one of the subcollector region, wherein one layer (43) of non-monocrystalline silicon is deposited on said epitaxially grown layer (15') and implanted with ions of the conductivity type of the subcollector region, characterized in that at least part of the non-monocrystalline silicion forms a spatial region for the emitter region which is adjacent to and at least partially vertically displaced from said base region, that the spatial region of the emitter region is bombarded with ions of such dose and high energy that at least a part of the Gaussion distribution of the penetration depths of those ions is diven across the boundary between said non-monocrystalline layer (43) and said epitaxial layer (15'), and the transistor is annealed in order to driven the ions into the base region and to convert the non-monocrystalline silicon of the spatial region of the emitter region to an emitter region consisting of monocrystalline silicon.

2. Method in accordance with claim 1, characterized in that said non-monocrystalline layer (43) is deposited with a thickness of between about 50 nm and 150 nm.

3. Method in accordance with claim 1 or 2, characterized in that the spatial region of the emitter region (47) is bombarded with a combination of doping ions and neutral ions.

4. Method in accordance with one of the claims 1 through 3, characterized in that the transistor is heated for annealing to a temperature and for a period of time sufficient for converting the non-monocrystalline silicon of the spatial region of the emitter region to an emitter region consisting of mono-crystalline silicon.

5. Method in accordance with claim 4, characterized in that the heat treatment is performed at a temperature between about 800° C and 1000° C for a period of 30 min through 4 h.

## Revendications

1. Procédé pour la formation de la zone d'émetteur d'un transistor, avec une zone de sous-collecteur (13') disposée dans un substrat semi-conducteur, avec une couche (15') de croissance épitaxiale, se situant au dessus, et avec, se situant à l'intérieur de cette couche, une zone de base (27') d'un type de conduction opposé au type de conduction de la zone du sous-collecteur, dans lequel une couche (43) de silicium non-monocristallin est déposée au dessus de la couche (15') de croissance épitaxiale et est implantée avec des ions du même type de conduction que celui de la zone du sous-collecteur, caractérisé, en ce qu'au minimum une partie du silicium non-monocristallin forme un domaine d'espace pour la zone d'émetteur qu'avoisine la zone de base et en est partiellement écartée dans le sens vertical, en ce que le domaine d'espace de la zone d'émetteur est irradié par des ions avec un dosage tel et une énergie si élevés qu'une partie au moins de la répartition gaussienne des profondeurs de pénétration de ces ions par dessus la surface de séparation est décalée entre la couche (43) non-monocristalline et la couche épitaxiale (15'), et en ce que le transistor est mis au recuit pour l'enfoncement des ions dans la zone de base, et pour convertir le silicium non-monocristallin du domaine d'espace de la zone d'émetteur en une zone d'émetteur se composant de silicium monocristallin.

2. Procédé selon la revendication 1, caractérisé en ce que la couche (43) non-monocristalline est appliquée avec une épaisseur d'environ 50 jusqu'à environ 150 nm.

3. Procédé selon la revendication 1 ou 2, caractérisé en ce que le domaine d'espace de la zone d'émetteur (47) est irradié avec une combinaison d'ions dopants et d'ions neutres.

4. Procédé selon l'une des revendications 1 à 3, caractérisé en ce que le transistor, pour le recuit, est échauffé pour un temps suffisamment long sur une température suffisante pour convertir le silicium non-monocristallin du domaine d'espace de la zone d'émetteur en une zone d'émetteur se composant de silicium monocristallin.

5. Procédé selon la revendication 4, caractérisé en ce que le traitement thermique est effectué avec une température d'environ 800° C jusqu'à 1000° C environ, pour environ 30 minutes jusqu'à environ 4 heures.

FIG. 1

FIG. 2

FIG. 3

FIG. 4

FIG. 5

FIG. 6

FIG. 7

FIG. 8

FIG. 9

POLYKRISTALLINE SCHICHT    MONOKRISTALLINE SCHICHT

IONEN-
KONZENTRATION

EINDRINGTIEFE VON DER IMPLANTATIONS-
OBERFLÄCHE

FIG. 15

FIG. 10

FIG. 11

FIG. 12

FIG. 13

FIG. 14